# EUROPEAN PATENT SPECIFICATION

(11) **EP 4 220 532 B1**
(45) Date of publication and mention of the grant of the patent: **06.05.2026**
(21) Application number: 21872405.2
(22) Date of filing: 21.09.2021
(51) Int. Cl.: G06Q 50/08, G06Q 50/10

(54) **STRUCTURE REPAIR ASSISTANCE DEVICE, METHOD, AND PROGRAM**
VORRICHTUNG, VERFAHREN UND PROGRAMM ZUR UNTERSTÜTZUNG VON STRUKTURREPARATUREN
DISPOSITIF, PROCÉDÉ ET PROGRAMME D'AIDE À LA RÉPARATION DE STRUCTURE

(30) Priority: 25.09.2020 JP 2020160940
(43) Date of publication of application: 02.08.2023
(73) Proprietor: FUJIFILM Corporation, Tokyo 106-8620 (JP)
(72) Inventor: OZEKI, Makoto, Tokyo 106-8620 (JP)
(74) Representative: Meissner Bolte Partnerschaft mbB
(86) International application number: PCT/JP2021/034507
(87) International publication number: WO 2022/065276

(56) References cited:
- WO-A1-2020/110587
- WO-A1-2020/110717
- JP-A- 2007 140 608
- JP-A- 2019 057 192
- JP-A- 2020 085 546

## Description

### BACKGROUND OF THE INVENTION

### 1. Field of the Invention

The present invention relates to a construction repair support apparatus, a construction repair support method, and a construction repair support program and specifically relates to a technique for presenting the determination basis for repair design information for a construction when the repair design information is automatically generated.

### 2. Description of the Related Art

To address labor shortages and increased costs caused by obligated inspections of constructions including bridges and tunnels, ICT (Information and Communication Technology) are being increasingly used in maintenance of constructions.

For example, automatic generation of repair design information by using artificial intelligence (AI) and by learning structural data, damage data, and repair data of constructions is being studied.

When repair design information is automatically generated by using a computer, it is difficult to search for the determination basis for the repair design information, and the details of processing specifically in machine learning and AI are a black box, and therefore, the process of determination is unknown and the user is unable to understand and be convinced of the repair design information, which is a problem.

In the related art, an inference apparatus that infers a class among predetermined classes to which an input image belongs, by inference using a neural network has been proposed (JP2019-82883A).

The inference apparatus includes: an input unit; a frequently appearing feature value database in which frequently appearing feature values that frequently appear in an inference process in a neural network are classified into classes and stored; an inference unit that infers a class to which an input image belongs, by inference using the neural network; a representative feature value extraction unit that extracts feature values appearing in an inference process in the inference and extracts feature values, among the feature values, that satisfy a predetermined condition as representative feature values; a basis feature value extraction unit that extracts basis feature values on the basis of the frequently appearing feature values and the representative feature values; and an output unit that outputs the basis feature values together with the inferred class.

The basis feature value extraction unit extracts the intersection of two sets, namely, the set of the frequently appearing feature values and the set of the representative feature values, as the basis feature values.

JP 2020 085546 A discloses a system for supporting inspection and repair of a structure, that automatically extracts a region of interest as an inspection range appropriate for inspection, from images containing damaged parts photographed by an inspector, and then displays the region of interest.

### SUMMARY OF THE INVENTION

For the inference apparatus described in JP2019-82883A, the frequently appearing feature value database in which frequently appearing feature values that frequently appear are classified into classes and stored needs to be prepared. Further, JP2019-82883A does not describe automatic generation of repair design information for a construction or indicate a new issue that, specifically when repair design information is automatically generated, the user is unable to understand and be convinced of the determination basis for the repair design information.

In one embodiment of the technique of the present disclosure, there are provided a construction repair support apparatus, a construction repair support method, and a construction repair support program with which repair design information for a construction can be automatically generated and the determination basis for the repair design information can be presented to the user.

The present invention is defined by independent claim 1 as appended. Further preferable embodiments are given in the dependent claims. According to claim 1, a construction repair support apparatus is provided which includes a processor, the processor being configured to perform an information acquisition process of acquiring construction information concerning a construction, a repair design information generation process of generating repair design information concerning a repair of damage in the construction on the basis of the construction information and damage information concerning the damage in the construction, a determination basis generation process of generating information that contributes to generation of the repair design information, as determination basis information for the repair design information, and a display process of causing a display device to display the repair design information and the determination basis information.

In the construction repair support apparatus, when repair design information concerning a repair of damage in a construction is automatically generated, determination basis information that is information contributing to generation of the repair design information is generated and the determination basis information is presented, and therefore, the user can easily understand the determination basis for the repair design information.

**In** the construction repair support apparatus, the processor is configured to acquire positional information about the damage in the construction, and cause the display device to display the repair design information in association with the positional information. Accordingly, the user can grasp the position of the damage in the construction to which the repair design information corresponds.

**In** the construction repair support apparatus, the construction information includes three-dimensional information that indicates the entire construction, and the processor is configured to cause the display device to display the construction three-dimensionally on the basis of the three-dimensional information, and cause the repair design information to be displayed at a corresponding position on the three-dimensionally displayed construction, on the basis of the positional information about the damage.

Accordingly, the user can grasp the position of the damage to which the repair design information corresponds, on the three-dimensionally displayed construction.

In the construction repair support apparatus, the processor is configured to perform a process of accepting switching between overall display and local display of the construction, and the processor is configured to in response to accepting switching from the overall display to the local display and the positional information about the damage, switch display on the display device from the overall display of the construction based on the three-dimensional information to the local display that includes an image of a position indicated by the positional information about the damage, and cause the display device to display the determination basis information associated with the positional information about the damage, and in response to accepting switching from the local display to the overall display, switch display on the display device to the overall display, and cause the display device to display the repair design information in association with the positional information about the damage.

According to the present invention, display can be switched between the overall display of the construction based on the three-dimensional information and the local display, and the user can confirm on the overall display, the repair design information associated with the positional information about the damage and can confirm the determination basis information for the repair design information on the local display.

Preferably, the construction repair support apparatus according to another aspect of the present invention further includes a database that stores the construction information and the damage information, in which the processor is configured to perform a damage information generation process of generating the damage information on the basis of a two-dimensional image of the construction included in the construction information, and store the damage information in the database in association with the construction information, and in the information acquisition process, the construction information and the damage information associated with the construction information are acquired from the database.

Preferably, the construction repair support apparatus according to another aspect of the present invention further includes a database that stores the construction information, in which in the information acquisition process, the construction information is acquired from the database, and in the repair design information generation process, the damage information is generated on the basis of a two-dimensional image of the construction included in the construction information, the construction information being acquired in the information acquisition process, and the repair design information concerning a repair of the damage in the construction is generated on the basis of the construction information and the damage information.

In the construction repair support apparatus according to another aspect of the present invention, preferably, in response to acquiring a plurality of pieces of determination basis information including the determination basis information, the processor is configured to calculate pieces of degree-of-contribution information that respectively indicate percentages of contribution of the plurality of pieces of determination basis information to generation of the repair design information, and cause the display device to display the pieces of degree-of-contribution information respectively corresponding to the plurality of pieces of determination basis information. Accordingly, the user can confirm which piece of determination basis information contributes to generation of the repair design information to what degree and can reflect the confirmation to, for example, a repair method.

In the construction repair support apparatus according to another aspect of the present invention, preferably, the determination basis information includes region information about a region, on the construction, to which attention is to be paid. The region information, about a region on the construction, contributing to generation of the repair design information can be presented as basis information for the repair design information.

In the construction repair support apparatus according to another aspect of the present invention, preferably, in the repair design information generation process, the repair design information is generated on the basis of pieces of damage information at a plurality of time points, and the determination basis information includes a degree of a change over time in the pieces of damage information between the plurality of time points. Accordingly, the degree of development of damage can be used as basis information for the repair design information.

In the construction repair support apparatus according to another aspect of the present invention, preferably, the processor is configured to perform a process of accepting specifying of the repair design information by a user, and in response to accepting specifying of the repair design information, cause the display device to display the determination basis information corresponding to the repair design information.

In the construction repair support apparatus according to another aspect of the present invention, preferably, the processor is configured to perform a process of accepting specifying of the determination basis information by a user, and in response to accepting specifying of the determination basis information, cause the display device to display the repair design information corresponding to the determination basis information.

In the construction repair support apparatus according to another aspect of the present invention, the processor includes a first learning model configured to perform the repair design information generation process, and the first learning model outputs the repair design information in response to input of the construction information or input of the construction information and the damage information.

In the construction repair support apparatus according to another aspect of the present invention, preferably, in the determination basis generation process performed by the processor, a calculation process for an output result of the first learning model is traced back and the determination basis information that affects the output result is extracted.

In the construction repair support apparatus according to another aspect of the present invention, the processor includes a second learning model configured to perform the damage information generation process, and the second learning model outputs the damage information about the construction in response to input of a two-dimensional image of the construction.

In the construction repair support apparatus according to another aspect of the present invention, preferably, the construction information includes at least one of drawing information about the construction, three-dimensional information that indicates the entire construction, a two-dimensional image that shows a local part of the construction, or text information concerning the construction.

In the construction repair support apparatus according to another aspect of the present invention, preferably, the construction information includes at least one of structural information, repair history information, environmental information, or monitoring information about the construction.

In the construction repair support apparatus according to another aspect of the present invention, preferably, the repair design information includes at least one of a cause of damage, a countermeasure method, a degree of soundness, necessity of repair, degradation prediction, or a countermeasure category.

In the construction repair support apparatus according to another aspect of the present invention, preferably, the determination basis information includes at least one of the damage information, the construction information, or environmental information.

In the construction repair support apparatus according to another aspect of the present invention, preferably, the damage information includes at least one of a damage type, a damage shape, a degree of damage, a degree of development of damage, a damaged region, a damage position, or similar damage.

The present invention is also defined by independent claim 11.

The present invention is also defined by independent claim 12.

According to the present invention, when repair design information for a construction is automatically generated, the determination basis for the repair design information can be presented. Accordingly, the user can understand and be convinced of the automatically generated repair design information and can refer to the determination basis for the repair design information upon a repair of the construction.

### BRIEF DESCRIPTION OF THE DRAWINGS

Fig. 1 is a block diagram illustrating an embodiment of a hardware configuration of a construction repair support apparatus according to the present invention;
Fig. 2 is a block diagram illustrating a first embodiment of a construction repair support apparatus according to the present invention;
Fig. 3 is a table illustrating a list of determination results and determination basis information for various repair design items;
Fig. 4 is a diagram illustrating a flow in which a CNN infers a determination result for a cause of damage (forward propagation);
Fig. 5 is a diagram illustrating a flow in which the CNN infers from the determination result for the cause of damage, the determination basis for the determination result (back propagation);
Fig. 6 is a diagram illustrating cross-reference relationships between determination results and determination bases;
Fig. 7 is a diagram illustrating a first example of determination basis presentation displayed on an output unit;
Fig. 8 is a diagram illustrating a second example of determination basis presentation displayed on the output unit;
Fig. 9 is a diagram illustrating a third example of determination basis presentation displayed on the output unit;
Figs. 10A and 10B are diagrams illustrating switching between overall display of a construction displayed three-dimensionally and local display;
Fig. 11 is a diagram illustrating an example of a list of text information of repair design information and text information of determination basis information that are associated with each other in the list;
Fig. 12 is a block diagram illustrating a second embodiment of a construction repair support apparatus according to the present invention; and
Fig. 13 is a flowchart illustrating an embodiment of a construction repair support method according to the present invention.

### DESCRIPTION OF THE PREFERRED EMBODIMENTS

Hereinafter, preferred embodiments of a construction repair support apparatus, a construction repair support method, and a construction repair support program according to the present invention will be described with reference to the attached drawings.

### Hardware Configuration of Construction Repair Support Apparatus

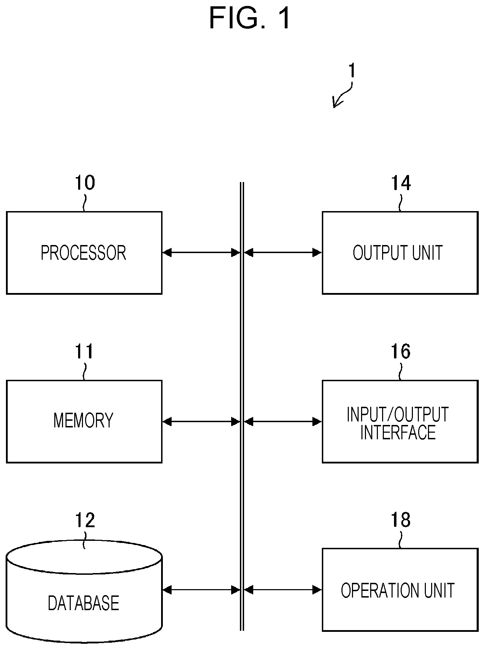

Fig. 1 is a block diagram illustrating an embodiment of a hardware configuration of a construction repair support apparatus according to the present invention.

As illustrated in Fig. 1, a construction repair support apparatus 1 can be formed of, for example, a personal computer or a workstation and includes a processor 10, a memory 11, a database 12, an output unit 14, an input/output interface 16, and an operation unit 18.

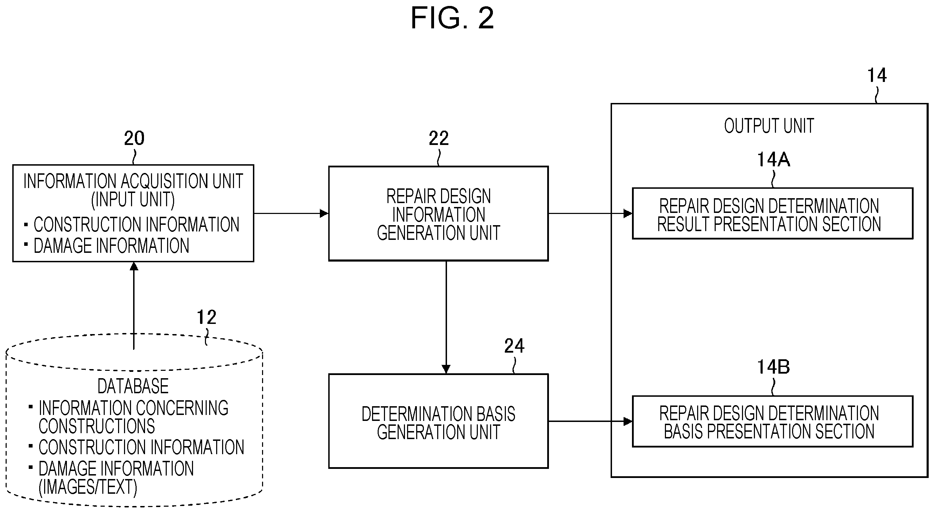

The processor 10 is formed of a CPU (central processing unit) and so on, centrally controls units of the construction repair support apparatus 1, and functions as, for example, an information acquisition unit (input unit) 20, a repair design information generation unit 22, and a determination basis generation unit 24 illustrated in Fig. 2.

The repair design information generation unit 22 is a unit that generates repair design information concerning a repair of damage in a construction, on the basis of, for example, construction information concerning the construction, and the determination basis generation unit 24 is a unit that generates information contributing to generation of the repair design information, as determination basis information for the repair design information. The repair design information generation unit 22, the determination basis generation unit 24, and so on will be described in detail below.

The memory 11 includes a flash memory, a ROM (read-only memory), and a RAM (random access memory). The flash memory and the ROM are nonvolatile memories that store, for example, an operating system and various programs including a construction repair support program according to the present invention. The RAM functions as a work area for processing by the processor 10. The RAM temporarily stores, for example, the construction repair support program stored in, for example, the flash memory. Note that the processor 10 may include a part (RAM) of the memory 11.

The processor 10 controls the units of the construction repair support apparatus 1 and performs processes in accordance with the construction repair support program while using the RAM as a work area.

The database 12 is a unit that stores and manages information concerning constructions. Here, information concerning constructions include construction information concerning constructions and damage information concerning damage in constructions. The construction information and the damage information in this example will be described in detail below.

The output unit 14 is a display device that displays repair design information generated by the construction repair support apparatus 1 and determination basis information that contributes to generation of the repair design information. The output unit 14 performs overall display of, for example, a three-dimensional image that shows the entire construction, local display of a two-dimensional image that shows a local part of a construction, and display of, for example, a damage image and a damage diagram, and is further used as part of a user interface for accepting an instruction from the user.

The input/output interface 16 includes a connection unit that can be connected to an external device and a communication unit that can be connected to a network. To the connection unit that can be connected to an external device, for example, USB (Universal Serial BUS) or HDMI (High-Definition Multimedia Interface) (HDMI is a registered trademark) can be applied.

The construction repair support apparatus 1 can acquire, for example, construction information concerning a desired construction and damage information concerning damage in the construction through the input/output interface 16. When necessary information can be acquired through the input/output interface 16, the database 12 might not be used.

The operation unit 18 includes a keyboard and a pointing device such as a mouse and functions as a user interface for accepting various items specified by the user. The operation unit 18 may include a touch panel.

### First Embodiment of Construction Repair Support Apparatus

Fig. 2 is a block diagram illustrating a first embodiment of a construction repair support apparatus according to the present invention.

The construction repair support apparatus of the first embodiment illustrated in Fig. 2 is formed of the processor 10, the database 12, and the output unit 14 of the construction repair support apparatus 1 having the hardware configuration illustrated in Fig. 1, and the processor 10 functions as the information acquisition unit 20, the repair design information generation unit 22, and the determination basis generation unit 24.

The information acquisition unit 20 that functions as an input unit acquires from the database 12, construction information concerning a desired construction and damage information concerning damage in the construction in accordance with a selection instruction from the user.

### Construction Information

Construction information includes at least one of drawing information (for example, CAD (computer-aided design) information) about a construction, three-dimensional information that indicates the entire construction, a two-dimensional image (captured image) that shows a local part of a construction, or text information concerning a construction. Three-dimensional information is, for example, a three-dimensional image, three-dimensional CAD information, or three-dimensional point cloud data.

Further, construction information includes at least one of structural information, repair history information, environmental information, or monitoring information about a construction.

Examples of structural information and so on about a construction when the construction is a bridge are listed below.
. Structural information about the construction: the form of bridge (for example, a truss bridge, an arch bridge, or a suspension bridge), the bridge length, the type of work (for example, superstructure work or substructure work), and the year of erection
· Repair history information: the type of repair and a repair method (for example, crack filling work or concrete re-pouring work)
· Environmental information: the position of erection, the volume of traffic, the climate, and a disaster history
· Monitoring information: the results of measurement by a vibrometer that measures vibrations of the construction and by a stress meter that measures stress on the construction, the types of sensors including the vibrometer, the stress meter, and a camera that captures an image of the construction, and the positions of sensors

### Damage Information

Damage information concerning damage in a construction includes at least one of the damage type, the damage shape, the degree of damage, the degree of development of damage, the damaged region, the damage position, or similar damage.

Examples of damage types are listed below.
· Typical damage in concrete members: cracks, peeling/exposure of reinforcing rods, water leakage/free lime, and concrete bulges
· Typical damage in steel members: corrosion, fractures, ruptures, and loosening/falling off

The repair design information generation unit 22 generates repair design information concerning a repair of damage in a construction on the basis of construction information concerning the construction and damage information acquired by the information acquisition unit 20.

### Repair Design Information

Repair design information includes at least one of the cause of damage in a construction, a countermeasure method, the degree of soundness, the necessity of repair, degradation prediction, or a countermeasure category.

The types of the cause of damage include fatigue, salt damage, frost damage, an alkali-aggregate reaction, and neutralization in a case of concrete members and fatigue and material degradation in a case of steel members.

Examples of a countermeasure method include a pouring-into-crack method, a concrete protection method, a cross-section repair method, an electric anticorrosion method, and floor slab concrete re-pouring work.

As indicators of the degree of soundness, various indicators are specified by the country and local governments and, for example, indicators indicating diagnosis results at four levels from I to IV are specified in the road/bridge periodic inspection guidelines (February, 2019) established by the Ministry of Land, Infrastructure, Transport and Tourism.

As a countermeasure category, for example, the following categories are specified in the bridge periodic inspection guidelines (March, 2019) established by the Ministry of Land, Infrastructure, Transport and Tourism.
A: Repairs are not necessary.
B: Repairs need to be made in accordance with the circumstances.
C1: Repairs and so on need to be immediately made from the viewpoint of preventive maintenance.
C2: Repairs and so on need to be immediately made from the viewpoint of the safety of the bridge structure.
E1: An emergency response needs to be made from the viewpoint of the safety of the bridge structure.
E2: An emergency response needs to be made for other purposes.
M: A response needs to be made by carrying out maintenance work.
S1: A close investigation needs to be carried out.
S2: A follow-up investigation needs to be carried out.

Although usually a person in charge of diagnosis visually inspects a damaged location of a construction in proximity to the construction, conducts a hammering test or other tests as necessary, and creates from the damage state and so on, repair design information (inference of the cause of damage, selection of a countermeasure method, determination of the degree of soundness, determination of the necessity of repair, degradation prediction, selection of a countermeasure category, and so on), the repair design information generation unit 22 in the present invention automatically generates repair design information on the basis of construction information and damage information concerning the construction.

The repair design information generation unit 22 can be formed of, for example, a trained model (first learning model) for which machine learning has been performed by using data sets of learning data including pairs of construction information and damage information, and repair design information corresponding to the construction information and damage information, and in response to input of construction information and damage information, outputs repair design information corresponding to the construction information and damage information as an inference result. Note that the repair design information generation unit 22 need not automatically generate repair design information by the first learning model and may automatically generate repair design information with an algorithm for generating repair design information.

The determination basis generation unit 24 extracts and generates information that contributes to generation of the repair design information by the repair design information generation unit 22, as determination basis information for the repair design information. The determination basis information includes at least one of damage information, construction information, or environmental information.

The repair design information generated by the repair design information generation unit 22 is output to the output unit 14 and displayed in a repair design determination result presentation section 14A of the output unit 14.

Similarly, the determination basis information generated by the determination basis generation unit 24 is output to the output unit 14 and displayed in a repair design determination basis presentation section 14B of the output unit 14.

Note that in Fig. 2, the repair design information generation unit 22 may include a trained model (second learning model) that performs a damage information generation process, and the second learning model may output, in response to input of a two-dimensional image of a construction, damage information about the construction. In this case, the repair design information generation unit 22 need not receive damage information about the construction from the information acquisition unit 20 and can use damage information output from the second learning model in response to input of an input image, that is, a two-dimensional image of the construction included in the construction information.

Further, in the first embodiment of the construction repair support apparatus, the database 12 need not be provided, and the information acquisition unit 20 can acquire necessary information from an external device or a network through the input/output interface 16.

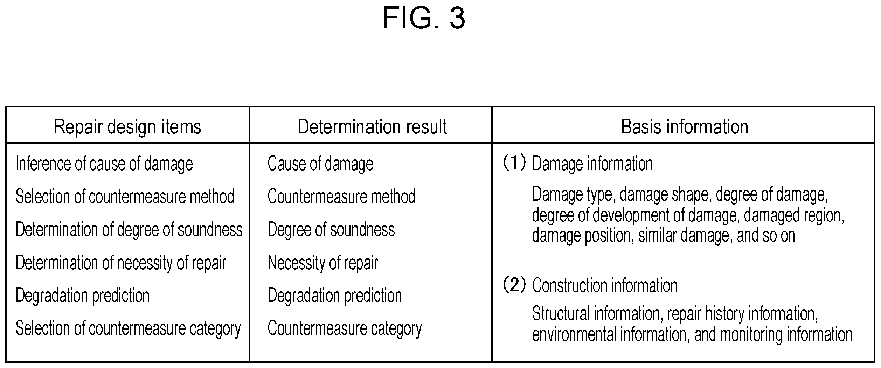

Fig. 3 is a table illustrating a list of determination results and determination basis information for various repair design items.

Although only with the repair design information presented in the repair design determination result presentation section 14A, the user may be unable to understand or be convinced of the determination basis for the repair design information, when repair design determination basis information is presented together with the repair design determination result as described above, the user can understand or be convinced of the determination basis for the repair design information.

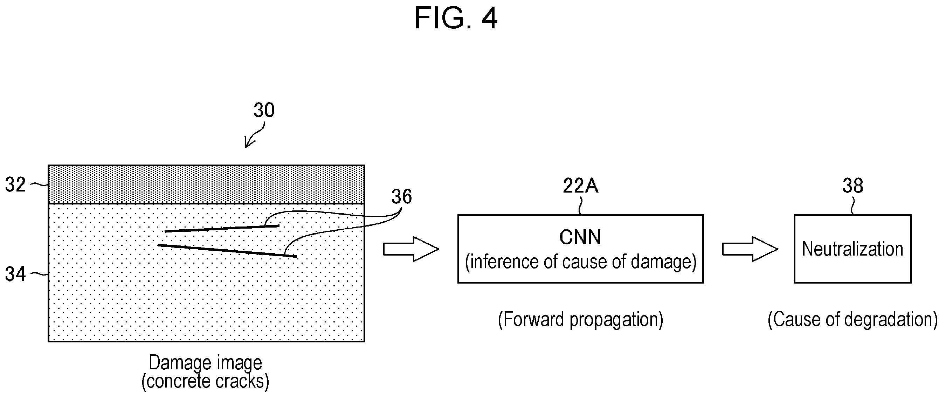

Fig. 4 is a diagram illustrating a flow in which a CNN (convolutional neural network) infers a determination result for a cause of damage (forward propagation).

In Fig. 4, when the repair design information generation unit 22 and the determination basis generation unit 24 are formed of a CNN 22A, as an input image, a damage image 30 is input to the CNN 22A that functions as the repair design information generation unit.

The CNN 22A infers repair design information concerning damage in the construction from features of the damage image 30 and outputs a determination result (repair design information). The damage image 30 in this example is a captured image 34 of a construction in which concrete cracks 36 occur along a steel member 32 (or a captured image on which a damage diagram showing cracks is superimposed and displayed), and the determination result is neutralization 38. The neutralization 38 is one of the causes of degradation (classes) and has external appearance features including cracks, rust, and concrete peeling along the axial direction of a steel member.

The CNN 22A outputs the neutralization 38 as the determination result from the above-described feature of the damage image 30.

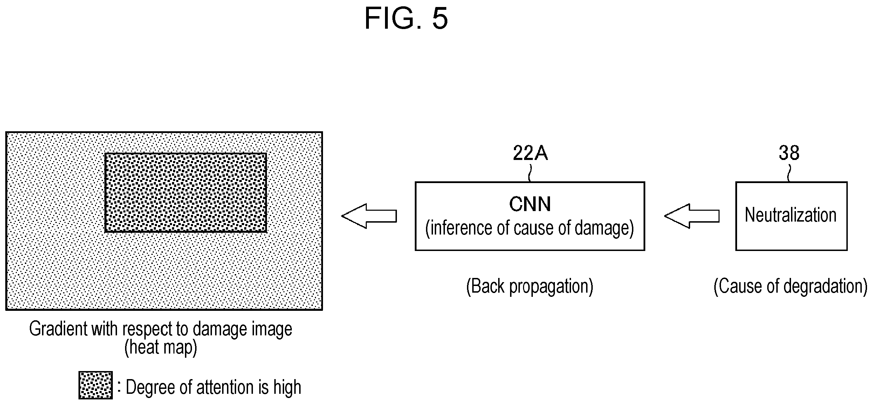

Fig. 5 is a diagram illustrating a flow in which the CNN infers from the determination result for the cause of damage, the determination basis for the determination result (back propagation).

In Fig. 5, when the repair design information generation unit 22 and the determination basis generation unit 24 are formed of the CNN 22A, the CNN 22A that functions as the determination basis generation unit calculates the calculation process for the output result backward and extracts determination basis information that affects the output result. In this example, the CNN 22A obtains a heat map 39 corresponding to the damage image 30 (Fig. 4).

As the heat map creation method, various methods are available and when, for example, Grad-CAM (Gradient-weighted Class Activation Mapping) is used, the gradient is calculated backward so as to maximize the probability value of the neutralization 38 that is the determination result and the heat map 39 is obtained as the determination basis for the neutralization 38. Alternatively, CAM, which is a base method for Grad-CAM, can be used. Further, as another method for creating a heat map (visualizing a region to which attention is to be paid) by the CNN, Attention is available.

In the heat map 39 illustrated in Fig. 5, a darker region is a region of a high degree of attention.

Therefore, the neutralization 38 can be presented as repair design information, and the heat map 39 can be presented as determination basis information therefor.

A heat map for a cause of degradation other than the neutralization 38 can be similarly calculated.

Further, a determination result and the determination basis can be cross-referenced to each other.

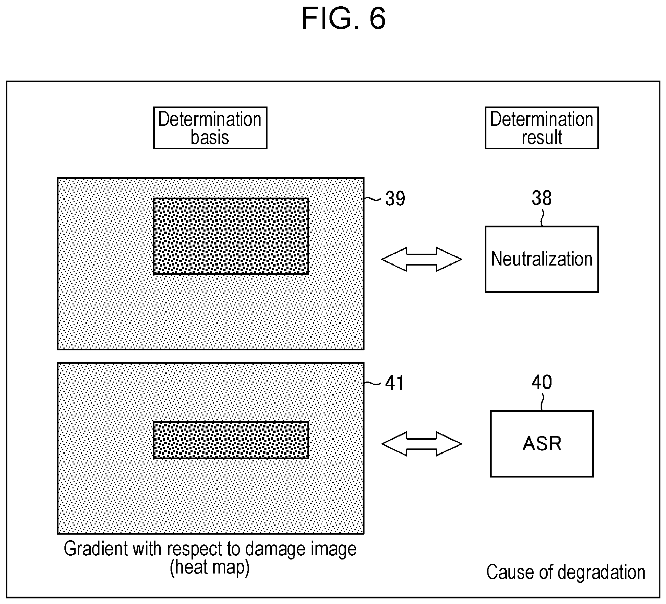

Fig. 6 is a diagram illustrating cross-reference relationships between determination results and determination bases.

In Fig. 6, when the user selects a cause of degradation, that is, the neutralization 38 or an ASR (alkali silica reaction) 40 presented in the determination result presentation section 14A, the processor 10 causes a corresponding heat map, that is, the heat map 39 or a heat map 41, to be displayed in the determination basis presentation section 14B. An ASR is one of the causes of degradation and has external appearance features including bulging cracks (in a restricted direction and having a hexagonal pattern), gel, and discoloration.

In response to the user giving an instruction for selecting a point (coordinates) on the heat map 39 or 41 presented in the determination basis presentation section 14B, the processor 10 can calculate estimated contribution percentages of the respective causes of degradation in accordance with the values on the heat map 39 or 41 and display the estimated contribution percentages in the determination result presentation section 14A together with the causes of degradation. For example, for a certain point on the heat map, 20% and 80% can be displayed for the neutralization and the ASR respectively.

Note that the method of presenting a determination basis as a heat map created by using, for example, Grad-CAM can be used for other than images.

### First Example of Determination Basis Presentation

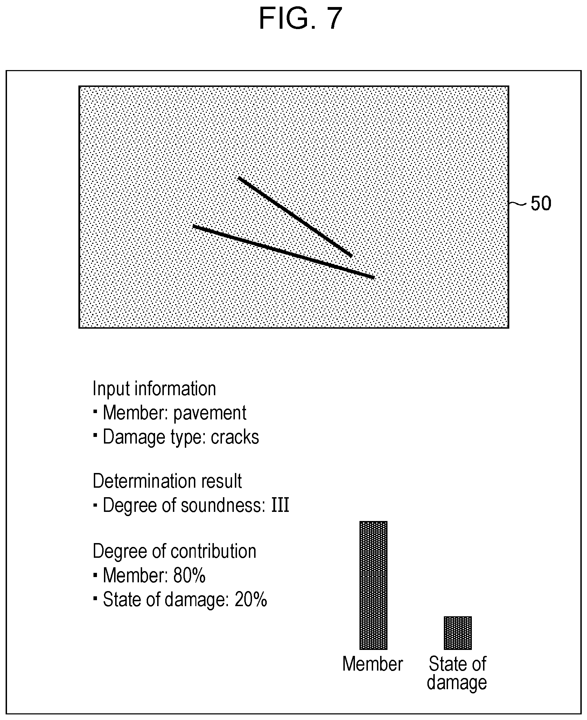

Fig. 7 is a diagram illustrating a first example of determination basis presentation displayed on the output unit.

In Fig. 7, the repair design determination result is a degree of soundness III. The degree of soundness **III** corresponds to a determination category "prompt action stage" and is a determination category that is defined as a state in which a prompt action is to be taken because of the possibility that the function of the road or bridge is impaired.

As the determination basis for this determination result, a damage image 50 is presented, and as input information, text information concerning the construction, that is, a member (pavement) and a damage type (cracks), is presented.

In the first example of determination basis presentation, in response to acquiring a plurality of pieces of determination basis information for the degree of soundness III, the processor 10 calculates degree-of-contribution information that includes a degree of contribution indicating the percentage of contribution of each of the plurality of pieces of determination basis information to generation of the degree of soundness III, by using heat maps as described above. In this example, as pieces of degree-of-contribution information for the member and the state of damage, the processor 10 calculates a degree of contribution 80% for the member and a degree of contribution 20% for the state of damage and causes these pieces of degree-of-contribution information to be displayed.

In the example illustrated in Fig. 7, the pieces of degree-of-contribution information for the member and the state of damage are displayed as numerical values and bar charts. Second Example of Determination Basis Presentation

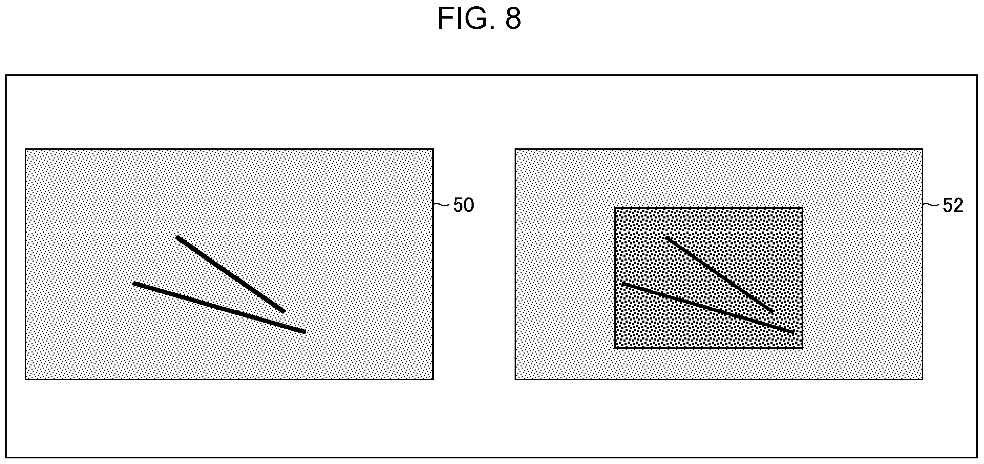

Fig. 8 is a diagram illustrating a second example of determination basis presentation displayed on the output unit.

In the second example of determination basis presentation illustrated in Fig. 8, the determination basis for a determination result is displayed as an image.

That is, as the determination basis for a determination result, the damage image 50 and a heat map 52 are displayed.

The heat map 52 is a heat map corresponding to the damage image 50 and obtained by the CNN 22A calculating the gradient backward so as to maximize the probability value of the determination result as illustrated in Fig. 5. It is preferable to display the heat map 52 so as to be color-coded or shaded in accordance with the values on the heat map to thereby allow region information about a region (for example, a region having a high or low degree of attention) to which attention is to be paid with respect to the determination result, to be visually identified at a plurality of levels. Note that the number of levels in region information according to the degree of attention can be set as desired.

### Third Example of Determination Basis Presentation

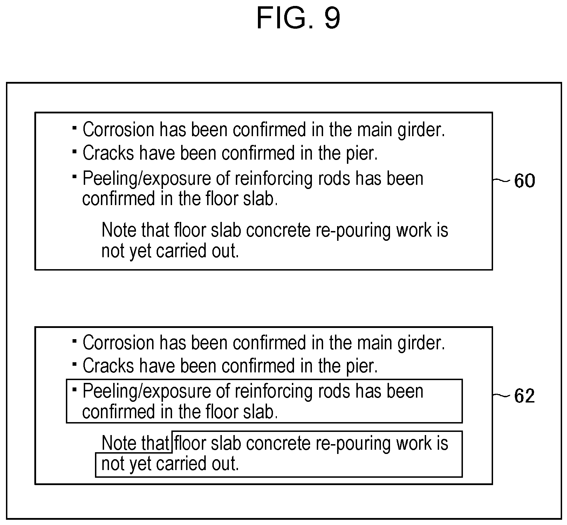

Fig. 9 is a diagram illustrating a third example of determination basis presentation displayed on the output unit.

In the third example of determination basis presentation illustrated in Fig. 9, for example, the determination basis for a determination result is displayed as text.

In Fig. 9, in response to input of text information 60 illustrated in Fig. 9 concerning a construction to the repair design information generation unit 22, the repair design information generation unit 22 extracts from the text information 60, text that serves as keywords corresponding to repair design information (in this example, "floor slab concrete re-pouring work is not yet carried out") and extracts text that serves as keywords corresponding to determination basis information (in this example, "peeling/exposure of reinforcing rods has been confirmed in the floor slab").

"Floor slab concrete re-pouring work" is a repair method that is performed when the floor slab of a bridge is significantly damaged and the floor slab is unable to be satisfactorily maintained with temporary measures or a maintenance method.

The processor 10 causes the output unit 14 to display the text information 60 and text information 62 in which the extracted text is highlighted.

Although the text information 62 in which the extracted text is highlighted by boxing the extracted text is displayed in this example, alternatively, the extracted text may be highlighted by coloring the extracted text, for example, red. Instead of the text information 62, text information, such as "repair design information: floor slab concrete re-pouring work" and "determination basis information: peeling/exposure of reinforcing rods in floor slab", may be generated and displayed.

### Three-Dimensional Display

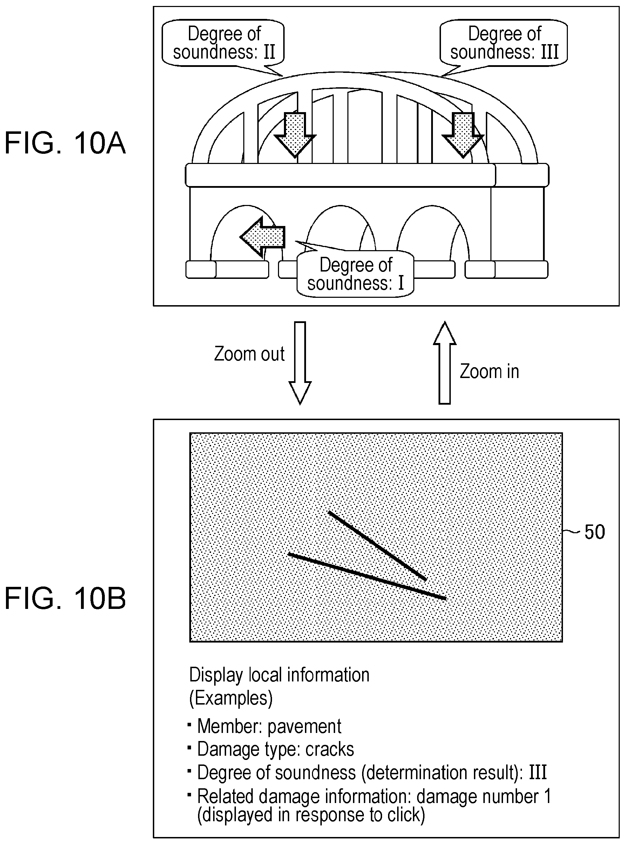

Figs. 10A and 10B are diagrams illustrating switching between overall display of a construction displayed three-dimensionally and local display.

Construction information includes three-dimensional information (in this example, a three-dimensional image) that indicates the entire construction, and the processor 10 can cause the output unit 14 to three-dimensionally display the construction on the basis of the three-dimensional image acquired by the information acquisition unit 20.

Fig. 10A illustrates a display screen of overall display on the output unit 14 on which the construction is displayed as a three-dimensional image.

On the three-dimensional image in overall display, locations for which the determination results of repair design information are obtained are highlighted with, for example, indicators such as arrows and/or highlighting. The processor 10 can cause the output unit 14 to display, on the basis of positional information about a location for which the determination result is obtained, repair design information associated with the positional information.

Fig. 10B illustrates a display screen of local display on the output unit 14 on which a certain one location of the construction for which the determination result is obtained is displayed.

Local display can be performed by displaying a two-dimensional image (in this example, the damage image 50) showing a local part of the construction.

As illustrated in Fig. 10B, the processor 10 causes the output unit 14 to, for example, display the repair design determination result (in this example, the degree of soundness III), display a member (pavement) and a damage type (cracks) that are information contributing to generation of the degree of soundness III, and display related damage information (damage number 1) together with local display of the construction.

The processor 10 can switch between the overall display of the construction illustrated in Fig. 10A and the local display of the construction illustrated in Fig. 10B in response to accepting an instruction from the user.

In response to accepting switching of display in the overall display state and positional information about damage to be locally displayed, the processor 10 switches display on the output unit 14 from the overall display (Fig. 10A) to the local display (Fig. 10B).

For example, in response to the user operating the mouse and clicking on the position of damage, on the overall display screen, that is to be locally displayed (or on the display position of a determination result displayed in association with the position of damage), the processor 10 switches from the overall display (Fig. 10A) to the local display (Fig. 10B) that includes, for example, an image of the specified position of damage. In response to accepting a zooming operation for zooming in performed by, for example, a wheel operation of the mouse, the processor 10 can transition the display to the local display (Fig. 10B) while enlarging the overall display (Fig. 10A).

In contrast, in response to accepting switching from the local display to the overall display in the local display state, the processor 10 switches from the local display (Fig. 10B) to the overall display (Fig. 10A). For example, in response to accepting a zooming operation for zooming out performed by, for example, a wheel operation of the mouse, the processor 10 can transition the display to the overall display (Fig. 10A) while reducing the local display (Fig. 10B).

Note that a user operation for switching between overall display and local display is not limited to the above-described operation method using a mouse. For example, when the operation unit 18 includes a touch panel, an instruction for switching between overall display and local display can be given by, for example, a tap operation and pinch-in and pinch-out operations on the touch panel.

In response to the user inputting a request for viewing the details of damage information on the local display screen (for example, in response to a click on "damage number 1" in Fig. 10B), the processor 10 can cause other information concerning damage corresponding to "damage number 1" (for example, the damage shape, the degree of damage, and the degree of development of damage) to be displayed. When pieces of past damage information about the same damage are saved in the database 12, the degree of development of damage can be obtained on the basis of the difference between pieces of damage information at a plurality of time points (a piece of past damage information and a piece of current damage information), as information indicating the degree of a change over time in the pieces of damage information between the plurality of time points.

The local display is not limited to, for example, the damage image 50 that is a two-dimensional image and can be performed by enlarging a three-dimensional image that shows the entire construction and displaying a part of the three-dimensional image. Instead of a three-dimensional image, for example, overall display of a construction may be performed on the basis of other three-dimensional information, such as three-dimensional CAD (computer-aided design) data or three-dimensional point cloud data, about the construction.

### List Display

Repair design information generated by the repair design information generation unit 22 illustrated in Fig. 2 and determination basis information generated by the determination basis generation unit 24 illustrated in Fig. 2 can be associated with each other in a list.

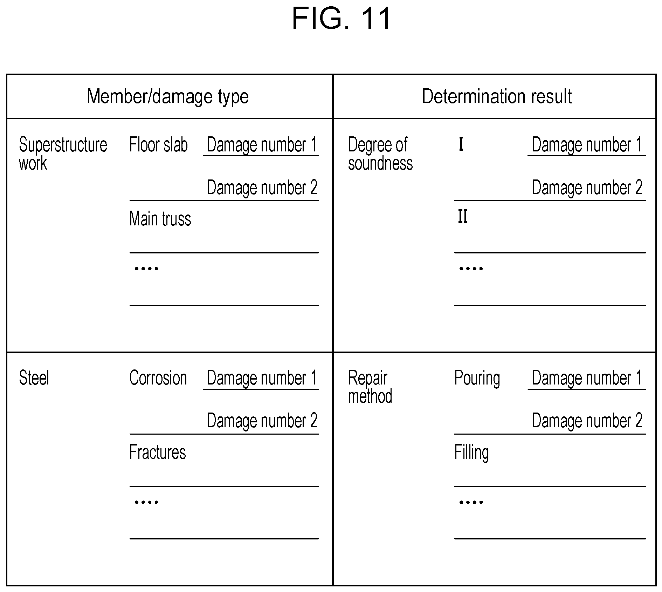

Fig. 11 is a diagram illustrating an example of a list of text information of repair design information and text information of determination basis information that are associated with each other in the list. The determination result for damage in a construction is one form of repair design information, and the member/damage type is one form of determination basis information.

In response to the user inputting an instruction for list display, the processor 10 can cause the output unit 14 to display the list as illustrated in Fig. 11.

In response to the user inputting an instruction for specifying, for example, a member/damage type or a determination result for damage, the processor 10 can perform sorting for the list, and in response to a click on, for example, "floor slab damage number 1" on the list illustrated in Fig. 11, the processor 10 can cause, for example, a damage image, a damage diagram, and text information corresponding to "floor slab damage number 1" to be displayed.

### Second Embodiment of Construction Repair Support Apparatus

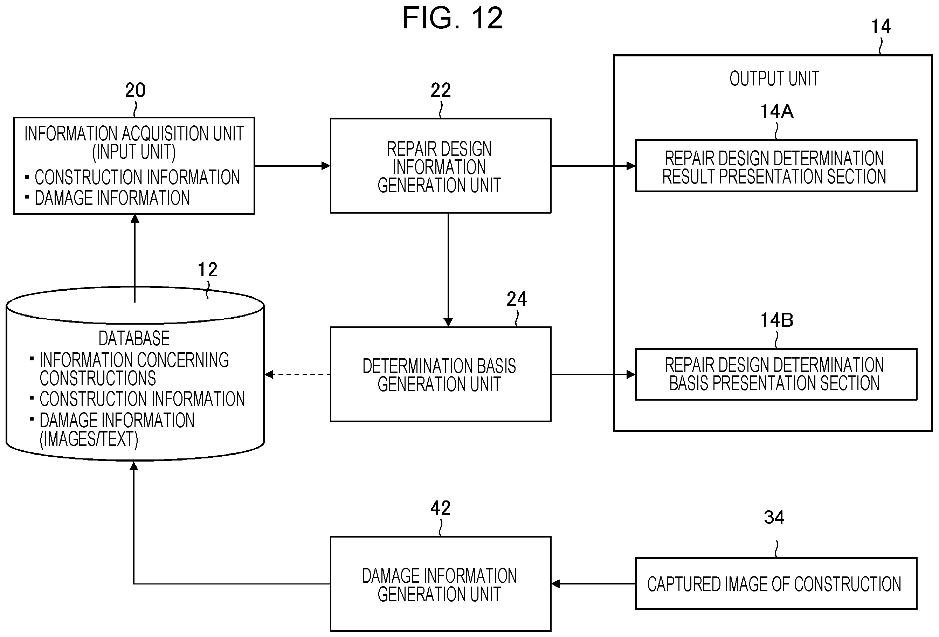

Fig. 12 is a block diagram illustrating a second embodiment of a construction repair support apparatus according to the present invention. In Fig. 12, a part common to the first embodiment of the construction repair support apparatus illustrated in Fig. 2 is assigned the same reference numeral and a detailed description thereof will be omitted.

The construction repair support apparatus of the second embodiment illustrated in Fig. 12 is different from the construction repair support apparatus of the first embodiment in that a damage information generation unit 42 is added.

In response to input of a captured image 34 of a construction, the damage information generation unit 42 generates, on the basis of the captured image 34, damage information including the type of damage in the construction present in the captured image 34, the damage shape, the degree of damage, the damaged region, and the damage position.

The damage information generation unit 42 can be formed of, for example, a trained model (third learning model) for which machine learning has been performed by using data sets of learning data including pairs of captured images of damage in constructions, and damage information concerning the damage in the captured images, and in response to input of the captured image 34 of a test target construction, outputs damage information concerning damage in the captured image as an inference result. Note that the damage information generation unit 42 need not automatically generate damage information by the third learning model and may automatically generate damage information with a detection algorithm for detecting damage information.

The damage information generated by the damage information generation unit 42 can be saved in the database 12 in association with construction information (for example, the captured image 34) corresponding to the damage information.

Further, repair design information generated by the repair design information generation unit 22 illustrated in Fig. 2 and determination basis information generated by the determination basis generation unit 24 illustrated in Fig. 2 may be associated with each other and saved in the database 12. Accordingly, recalculation is not necessary in the repair design information generation unit 22 or the determination basis generation unit 24, which is an advantage.

### Construction Repair Support Method

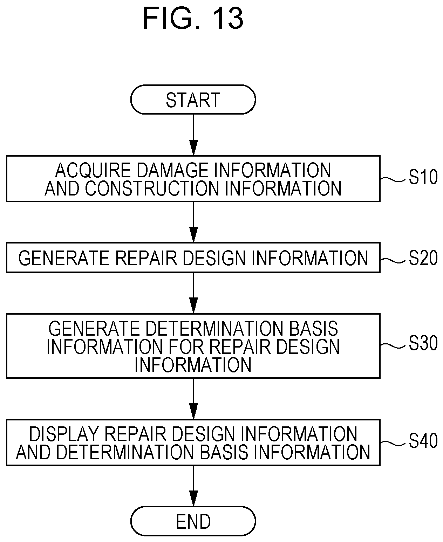

Fig. 13 is a flowchart illustrating an embodiment of a construction repair support method according to the present invention. The processes in respective steps illustrated in Fig. 13 are performed by the processor 10 of the construction repair support apparatus 1 illustrated in Fig. 1.

In Fig. 13, the processor 10 acquires, in accordance with a selection instruction from the user, construction information concerning a desired construction and damage information concerning damage in the construction from the database 12 (step S10, damage information acquisition process).

The processor 10 generates repair design information concerning a repair of the damage in the construction on the basis of the acquired construction information and damage information (step S20, repair design information generation process).

The processor 10 generates automatically or in response to an instruction for generation from the user, information that contributes to generation of the repair design information generated in step S20, as determination basis information for the repair design information (step S30, determination basis generation process).

The processor 10 outputs to and causes the output unit 14 to display the repair design information generated in step S20 and the determination basis information generated in step S30 (step S40, display process). Note that display of the repair design information and display of the determination basis information may be simultaneously performed on the same screen, or any one of the repair design information or the determination basis information may be displayed in accordance with a selection instruction from the user.

### Others

In the embodiments, the hardware configuration of the processing units including the CPU that perform various types of processing is implemented as various processors as described below. The various processors include a CPU (central processing unit) that is a general-purpose processor executing software (program) to function as various processing units, a programmable logic device (PLD), such as an FPGA (field-programmable gate array), that is a processor for which the circuit configuration can be changed after manufacturing, and a dedicated electric circuit, such as an ASIC (application-specific integrated circuit), having a circuit configuration that is designed only for performing a specific process.

One processing unit may be configured as one of the various processors or two or more processors of the same type or different types (for example, a plurality of FPGAs or a combination of a CPU and an FPGA). Further, a plurality of processing units may be configured as one processor. As the first example of configuring a plurality of processing units as one processor, a form is possible in which one or more CPUs and software are combined to configure one processor, and the processor functions as the plurality of processing units, a representative example of which is a computer, such as a client or a server. As the second example thereof, a form is possible in which a processor is used in which the functions of the entire system including the plurality of processing units are implemented as one IC (integrated circuit) chip, a representative example of which is a system on chip (SoC). As described above, regarding the hardware configuration, the various processing units are configured by using one or more of the various processors described above.

Further, the hardware configuration of the various processors is more specifically an electric circuit (circuitry) in which circuit elements, such as semiconductor elements, are combined.

Further, the present invention includes the construction repair support program that is installed in a computer to thereby cause the computer to function as the construction repair support apparatus according to the present invention, and a nonvolatile storage medium to which the construction repair support program is recorded.

### Reference Signs List

- 1: construction repair support apparatus
- 10: processor
- 11: memory
- 12: database
- 14: output unit
- 14A: determination result presentation section
- 14B: determination basis presentation section
- 16: input/output interface
- 18: operation unit
- 20: information acquisition unit
- 22: repair design information generation unit
- 22A: CNN
- 24: determination basis generation unit
- 30, 50: damage image
- 32: steel member
- 34: captured image
- 36: concrete crack
- 38: neutralization
- 39, 41, 52: heat map
- 42: damage information generation unit
- 60, 62: text information
- S10 to S40: step

## Claims

1. A construction repair support apparatus (1) comprising a processor (10),
the processor (10) being configured to perform
an information acquisition process of acquiring construction information concerning a construction,
a repair design information generation process of generating repair design information concerning a repair of damage in the construction on the basis of the construction information and damage information concerning the damage in the construction,
a determination basis generation process of generating information that contributes to generation of the repair design information, as determination basis information for the repair design information, and
a display process of causing a display device to display the repair design information and the determination basis information,
wherein
the processor (10) is configured to acquire positional information about the damage in the construction, and cause the display device to display the repair design information in association with the positional information,
the construction information includes three-dimensional information that indicates the entire construction,
the processor (10) is configured to cause the display device to display the construction three-dimensionally on the basis of the three-dimensional information, and cause the repair design information to be displayed at a corresponding position on the three-dimensionally displayed construction, on the basis of the positional information about the damage,
the processor (10) is configured to perform a process of accepting switching between overall display and local display of the construction, and
the processor (10) is configured to
in response to accepting switching from the overall display to the local display and the positional information about the damage, switch display on the display device from the overall display of the construction based on the three-dimensional information to the local display that includes an image of a position indicated by the positional information about the damage, and cause the display device to display the determination basis information associated with the positional information about the damage, and
in response to accepting switching from the local display to the overall display, switch display on the display device to the overall display, and cause the display device to display the repair design information in association with the positional information about the damage.

2. The construction repair support apparatus (1) according to claim 1, further comprising
a database (12) that stores the construction information and the damage information, wherein
the processor (10) is configured to perform a damage information generation process of generating the damage information on the basis of a two-dimensional image of the construction included in the construction information, and store the damage information in the database (12) in association with the construction information, and
in the information acquisition process, the construction information and the damage information associated with the construction information are acquired from the database (12).

3. The construction repair support apparatus (1) according to claim 1, further comprising
a database (12) that stores the construction information, wherein
in the information acquisition process, the construction information is acquired from the database (12), and
in the repair design information generation process,
the damage information is generated on the basis of a two-dimensional image of the construction included in the construction information, the construction information being acquired in the information acquisition process, and
the repair design information concerning a repair of the damage in the construction is generated on the basis of the construction information and the damage information.

4. The construction repair support apparatus (1) according to any one of claims 1 to 3, wherein
in response to acquiring a plurality of pieces of determination basis information including the determination basis information, the processor (10) is configured to calculate pieces of degree-of-contribution information that respectively indicate percentages of contribution of the plurality of pieces of determination basis information to generation of the repair design information, and cause the display device to display the pieces of degree-of-contribution information respectively corresponding to the plurality of pieces of determination basis information.

5. The construction repair support apparatus (1) according to any one of claims 1 to 4, wherein
the determination basis information includes region information about a region, on the construction, to which attention is to be paid.

6. The construction repair support apparatus (1) according to any one of claims 1 to 5, wherein
in the repair design information generation process, the repair design information is generated on the basis of pieces of damage information at a plurality of time points, and
the determination basis information includes a degree of a change over time in the pieces of damage information between the plurality of time points.

7. The construction repair support apparatus (1) according to any one of claims 1 to 6, wherein
the processor (10) is configured to perform a process of accepting specifying of the repair design information by a user, and in response to accepting specifying of the repair design information, cause the display device to display the determination basis information corresponding to the repair design information, and/or
the processor (10) is configured to perform a process of accepting specifying of the determination basis information by a user, and in response to accepting specifying of the determination basis information, cause the display device to display the repair design information corresponding to the determination basis information.

8. The construction repair support apparatus (1) according to any one of claims 1 to 7, wherein
the processor (10) includes a first learning model configured to perform the repair design information generation process, and
the first learning model outputs the repair design information in response to input of the construction information or input of the construction information and the damage information.

9. The construction repair support apparatus (1) according to claim 8, wherein
in the determination basis generation process performed by the processor (10), a calculation process for an output result of the first learning model is traced back and the determination basis information that affects the output result is extracted, and
for example,
in the determination basis generation process performed by the processor (10), information visualizing a region to which attention is to be paid of the first learning model, is generated corresponding to information input to the first learning model, as the determination basis information, and
preferably,
in the determination basis generation process performed by the processor (10), a heat map is generated as the information visualizing a region to which attention, and
more preferably,
in the determination basis generation process performed by the processor (10), the heat map is generated using Grad-CAM, CAM or Attention.

10. The construction repair support apparatus (1) according to claim 2, wherein
the processor (10) includes a second learning model configured to perform the damage information generation process, and
the second learning model outputs the damage information about the construction in response to input of a two-dimensional image of the construction.

11. A construction repair support method for a processor to perform
a step of acquiring construction information concerning a construction,
a step of generating repair design information concerning a repair of damage in the construction on the basis of the construction information and damage information concerning the damage in the construction,
a step of generating information that contributes to generation of the repair design information, as determination basis information for the repair design information, and
a step of causing a display device to display the repair design information and the determination basis information,
the method further comprising:
acquiring positional information about the damage in the construction, and causing the display device to display the repair design information in association with the positional information,
the construction information including three-dimensional information that indicates the entire construction;
causing the display device to display the construction three-dimensionally on the basis of the three-dimensional information, and causing the repair design information to be displayed at a corresponding position on the three-dimensionally displayed construction, on the basis of the positional information about the damage;
performing a process of accepting switching between overall display and local display of the construction;
in response to accepting switching from the overall display to the local display and the positional information about the damage, switching display on the display device from the overall display of the construction based on the three-dimensional information to the local display that includes an image of a position indicated by the positional information about the damage, and causing the display device to display the determination basis information associated with the positional information about the damage; and
in response to accepting switching from the local display to the overall display, switching display on the display device to the overall display, and causing the display device to display the repair design information in association with the positional information about the damage.

12. A non-transitory computer-readable recording medium to which a program for causing a computer to execute the construction repair support method according to claim 11 is recorded.

## Patentansprüche

1. Baureparatur-Unterstützungsvorrichtung (1), umfassend einen Prozessor (10),
wobei der Prozessor (10) so konfiguriert ist, dass er durchführt:
einen Informationserfassungsprozess des Erfassens von Bauinformationen in Bezug auf einen Bau,
einen Reparaturkonstruktionsinformationen-Erzeugungsprozess des Erzeugens von Reparaturkonstruktionsinformationen in Bezug auf eine Reparatur von Schaden bei dem Bau auf der Grundlage der Bauinformationen und Schadensinformationen in Bezug auf den Schaden bei dem Bau,
einen Bestimmungsgrundlagen-Erzeugungsprozess des Erzeugens von Informationen, die zur Erzeugung der Reparaturkonstruktionsinformationen beitragen, als Bestimmungsgrundlageninformationen für die Reparaturkonstruktionsinformationen, und
einen Anzeigeprozess des Veranlassens einer Anzeigevorrichtung, die Reparaturkonstruktionsinformationen und die Bestimmungsgrundlageninformationen anzuzeigen,
wobei
der Prozessor (10) so konfiguriert ist, dass er Positionsinformationen über den Schaden bei dem Bau erfasst und die Anzeigevorrichtung veranlasst, die Reparaturkonstruktionsinformationen in Verknüpfung mit den Positionsinformationen anzuzeigen,
die Bauinformationen dreidimensionale Informationen enthalten, die den gesamten Bau angeben,
der Prozessor (10) so konfiguriert ist, dass er die Anzeigevorrichtung veranlasst, den Bau auf der Grundlage der dreidimensionalen Informationen dreidimensional anzuzeigen, und veranlasst, dass die Reparaturkonstruktionsinformationen an einer entsprechenden Position auf dem dreidimensional angezeigten Bau auf der Grundlage der Positionsinformationen über den Schaden angezeigt werden,
der Prozessor (10) so konfiguriert ist, dass er einen Prozess des Annehmens von Umschalten zwischen Gesamtanzeige und lokaler Anzeige des Baus durchführt, und der Prozessor (10) so konfiguriert ist, dass er
als Reaktion auf Annehmen von Umschalten von der Gesamtanzeige auf die lokale Anzeige und die Positionsinformationen über den Schaden, Anzeige auf der Anzeigevorrichtung von der Gesamtanzeige des Baus auf der Grundlage der dreidimensionalen Informationen auf die lokale Anzeige, die ein Bild einer Position, die durch die Positionsinformationen über den Schaden angegeben wird, enthält, umschaltet und die Anzeigevorrichtung veranlasst, die Bestimmungsgrundlageninformationen, die mit den Positionsinformationen über den Schaden assoziiert sind, anzuzeigen, und
als Reaktion auf Annehmen von Umschalten von der lokalen Anzeige auf die Gesamtanzeige, Anzeige auf der Anzeigevorrichtung auf die Gesamtanzeige umschaltet und die Anzeigevorrichtung veranlasst, die Reparaturkonstruktionsinformationen in Verknüpfung mit den Positionsinformationen über den Schaden anzuzeigen.

2. Baureparatur-Unterstützungsvorrichtung (1) nach Anspruch 1, ferner umfassend eine Datenbank (12), die die Bauinformationen und die Schadensinformationen speichert, wobei
der Prozessor (10) so konfiguriert ist, dass er einen Schadensinformationen - Erzeugungsprozess des Erzeugens der Schadensinformationen auf der Grundlage eines zweidimensionalen Bildes des Baus, das bei den Bauinformationen enthalten ist, durchführt und die Schadensinformationen in der Datenbank (12) in Verknüpfung mit den Bauinformationen speichert, und
bei dem Informationserfassungsprozess die Bauinformationen und die Schadensinformationen, die mit den Bauinformationen assoziiert sind, aus der Datenbank (12) erfasst werden.

3. Baureparatur-Unterstützungsvorrichtung (1) nach Anspruch 1, ferner umfassend
eine Datenbank (12), die die Bauinformationen speichert, wobei
bei dem Informationserfassungsprozess die Bauinformationen aus der Datenbank (12) erfasst werden, und
bei dem Reparaturkonstruktionsinformationen-Erzeugungsprozess,
die Schadensinformationen auf der Grundlage eines zweidimensionalen Bildes des Baus, das bei den Bauinformationen enthalten ist, erzeugt werden, wobei die Bauinformationen bei dem Informationserfassungsprozess erfasst werden, und
die Reparaturkonstruktionsinformationen in Bezug auf eine Reparatur des Schadens bei dem Bau auf der Grundlage der Bauinformationen und der Schadensinformationen erzeugt werden.

4. Baureparatur-Unterstützungsvorrichtung (1) nach einem der Ansprüche 1 bis 3, wobei
als Reaktion auf Erfassen mehrerer Bestimmungsgrundlageninformationen, die die Bestimmungsgrundlageninformationen enthalten, der Prozessor (10) so konfiguriert ist, dass er Beitragsgradinformationen berechnet, die entsprechend Prozentsätze von Beitrag der mehreren Bestimmungsgrundlageninformationen zu Erzeugung der Reparaturkonstruktionsinformationen angeben, und die Anzeigevorrichtung veranlasst, die Beitragsgradinformationen anzuzeigen, die entsprechend den mehreren Bestimmungsgrundlageninformationen entsprechen.

5. Baureparatur-Unterstützungsvorrichtung (1) nach einem der Ansprüche 1 bis 4, wobei
die Bestimmungsgrundlageninformationen Bereichsinformationen über einen Bereich, dem Aufmerksamkeit zu widmen ist, bei dem Bau enthalten.

6. Baureparatur-Unterstützungsvorrichtung (1) nach einem der Ansprüche 1 bis 5, wobei
bei dem Reparaturkonstruktionsinformationen-Erzeugungsprozess die Reparaturkonstruktionsinformationen auf der Grundlage von Schadensinformationen zu mehreren Zeitpunkten erzeugt werden, und
die Bestimmungsgrundlageninformationen einen Grad einer Änderung im Laufe der Zeit bei den Schadensinformationen zwischen den mehreren Zeitpunkten enthalten.

7. Baureparatur-Unterstützungsvorrichtung (1) nach einem der Ansprüche 1 bis 6, wobei
der Prozessor (10) so konfiguriert ist, dass er einen Prozess des Annehmens von Spezifizieren der Reparaturkonstruktionsinformationen durch einen Benutzer durchführt und als Reaktion auf Annehmen von Spezifizieren der Reparaturkonstruktionsinformationen die Anzeigevorrichtung veranlasst, die Bestimmungsgrundlageninformationen, die den Reparaturkonstruktionsinformationen entsprechen, anzuzeigen, und/oder
der Prozessor (10) so konfiguriert ist, dass er einen Prozess des Annehmens von Spezifizieren der Bestimmungsgrundlageninformationen durch einen Benutzer durchführt und als Reaktion auf Annehmen von Spezifizieren der Bestimmungsgrundlageninformationen die Anzeigevorrichtung veranlasst, die Reparaturkonstruktionsinformationen, die den Bestimmungsgrundlageninformationen entsprechen, anzuzeigen.

8. Baureparatur-Unterstützungsvorrichtung (1) nach einem der Ansprüche 1 bis 7, wobei
der Prozessor (10) ein erstes Lernmodell enthält, das so konfiguriert ist, dass es den Reparaturkonstruktionsinformationen-Erzeugungsprozess durchführt, und
das erste Lernmodell die Reparaturkonstruktionsinformationen als Reaktion auf Eingabe der Bauinformationen oder Eingabe der Bauinformationen und der Schadensinformationen ausgibt.

9. Baureparatur-Unterstützungsvorrichtung (1) nach Anspruch 8, wobei
bei dem von dem Prozessor (10) durchgeführten Bestimmungsgrundlagen - Erzeugungsprozess ein Berechnungsprozess für ein Ausgabeergebnis des ersten Lernmodells zurückverfolgt wird und die Bestimmungsgrundlageninformationen, die das Ausgabeergebnis beeinflussen, extrahiert werden, und
zum Beispiel,
bei dem von dem Prozessor (10) durchgeführten Bestimmungsgrundlagen - Erzeugungsprozess Informationen, die einen Bereich, dem Aufmerksamkeit zu widmen ist, des ersten Lernmodells visualisieren, entsprechend Informationen, die in das erste Lernmodell eingegeben werden, als die Bestimmungsgrundlageninformationen erzeugt werden, und
bevorzugt,
bei dem von dem Prozessor (10) durchgeführten Bestimmungsgrundlagen - Erzeugungsprozess, eine Heatmap als die Informationen, die einen Bereich, dem Aufmerksamkeit, visualisieren, erzeugt wird, und
weiter bevorzugt,
bei dem von dem Prozessor (10) durchgeführten Bestimmungsgrundlagen - Erzeugungsprozess, die Heatmap unter Verwendung von Grad-CAM, CAM oder Attention erzeugt wird.

10. Baureparatur-Unterstützungsvorrichtung (1) nach Anspruch 2, wobei
der Prozessor (10) ein zweites Lernmodell enthält, das so konfiguriert ist, dass es den Schadensinformationen-Erzeugungsprozess durchführt, und
das zweite Lernmodell die Schadensinformationen über den Bau als Reaktion auf Eingabe eines zweidimensionalen Bildes des Baus ausgibt.

11. Baureparatur-Unterstützungsverfahren für einen Prozessor zum Durchzuführen von
einem Schritt des Erfassens von Bauinformationen in Bezug auf einen Bau,
einem Schritt des Erzeugens von Reparaturkonstruktionsinformationen in Bezug auf eine Reparatur von Schaden bei dem Bau auf der Grundlage der Bauinformationen und Schadensinformationen in Bezug auf den Schaden bei dem Bau,
einem Schritt des Erzeugens von Informationen, die zur Erzeugung der Reparaturkonstruktionsinformationen beitragen, als Bestimmungsgrundlageninformationen für die Reparaturkonstruktionsinformationen, und
einem Schritt des Veranlassens einer Anzeigevorrichtung, die Reparaturkonstruktionsinformationen und die Bestimmungsgrundlageninformationen anzuzeigen,
wobei das Verfahren ferner umfasst:
Erfassen von Positionsinformationen über den Schaden bei dem Bau und Veranlassen der Anzeigevorrichtung, die Reparaturkonstruktionsinformationen in Verknüpfung mit den Positionsinformationen anzuzeigen, wobei die Bauinformationen dreidimensionale Informationen enthalten, die den gesamten Bau angeben;
Veranlassen der Anzeigevorrichtung, den Bau auf der Grundlage der dreidimensionalen Informationen dreidimensional anzuzeigen, und Veranlassen, dass die Reparaturkonstruktionsinformationen an einer entsprechenden Position auf dem dreidimensional angezeigten Bau auf der Grundlage der Positionsinformationen über den Schaden angezeigt werden;
Durchführen eines Prozesses des Annehmens von Umschalten zwischen Gesamtanzeige und lokaler Anzeige des Baus;
als Reaktion auf Annehmen von Umschalten von der Gesamtanzeige auf die lokale Anzeige und die Positionsinformationen über den Schaden, Umschalten von Anzeige auf der Anzeigevorrichtung von der Gesamtanzeige des Baus auf der Grundlage der dreidimensionalen Informationen auf die lokale Anzeige, die ein Bild einer Position, die durch die Positionsinformationen über den Schaden angegeben wird, enthält, und Veranlassen der Anzeigevorrichtung, die Bestimmungsgrundlageninformationen, die mit den Positionsinformationen über den Schaden assoziiert sind, anzuzeigen; und
als Reaktion auf Annehmen von Umschalten von der lokalen Anzeige auf die Gesamtanzeige, Umschalten von Anzeige auf der Anzeigevorrichtung auf die Gesamtanzeige und Veranlassen der Anzeigevorrichtung, die Reparaturkonstruktionsinformationen in Verknüpfung mit den Positionsinformationen über den Schaden anzuzeigen.

12. Nicht flüchtiges computerlesbares Aufzeichnungsmedium, auf das ein Programm zum Veranlassen eines Computers, das Baureparatur-Unterstützungsverfahren nach Anspruch 11 auszuführen, aufgezeichnet ist.

## Revendications

1. Appareil de support de réparation de construction (1) comprenant un processeur (10), le processeur (10) étant configuré pour effectuer
un processus d'acquisition d'informations consistant à acquérir des informations de construction concernant une construction,
un processus de génération d'informations de conception de réparation consistant à générer des informations de conception de réparation concernant une réparation de dommages dans la construction sur la base des informations de construction et des informations de dommages concernant les dommages dans la construction,
un processus de génération de base de détermination consistant à générer des informations qui contribuent à la génération des informations de conception de réparation, en tant qu'informations de base de détermination pour les informations de conception de réparation, et
un processus d'affichage consistant à amener un dispositif d'affichage à afficher les informations de conception de réparation et les informations de base de détermination,
dans lequel
le processeur (10) est configuré pour acquérir des informations de position concernant les dommages dans la construction, et amener le dispositif d'affichage à afficher les informations de conception de réparation en association avec les informations de position,
les informations de construction incluent des informations tridimensionnelles qui indiquent l'ensemble de la construction,
le processeur (10) est configuré pour amener le dispositif d'affichage à afficher la construction de manière tridimensionnelle sur la base des informations tridimensionnelles, et amener les informations de conception de réparation à être affichées à une position correspondante sur la construction affichée de manière tridimensionnelle, sur la base des informations de position concernant les dommages,
le processeur (10) est configuré pour effectuer un processus consistant à accepter la commutation entre l'affichage global et l'affichage local de la construction, et le processeur (10) est configuré pour
en réponse à l'acceptation de la commutation de l'affichage global à l'affichage local et aux informations de position concernant les dommages, commuter l'affichage sur le dispositif d'affichage de l'affichage global de la construction sur la base des informations tridimensionnelles à l'affichage local qui inclut une image d'une position indiquée par les informations de position concernant les dommages, et amener le dispositif d'affichage à afficher les informations de base de détermination associées aux informations de position concernant les dommages, et
en réponse à l'acceptation de la commutation de l'affichage local à l'affichage global, commuter l'affichage sur le dispositif d'affichage à l'affichage global, et amener le dispositif d'affichage à afficher les informations de conception de réparation en association avec les informations de position concernant les dommages.

2. Appareil de support de réparation de construction (1) selon la revendication 1, comprenant en outre
une base de données (12) qui stocke les informations de construction et les informations de dommages, dans lequel
le processeur (10) est configuré pour effectuer un processus de génération d'informations de dommages consistant à générer les informations de dommages sur la base d'une image bidimensionnelle de la construction incluse dans les informations de construction, et stocker les informations de dommages dans la base de données (12) en association avec les informations de construction, et
dans le processus d'acquisition d'informations, les informations de construction et les informations de dommages associées aux informations de construction sont acquises à partir de la base de données (12).

3. Appareil de support de réparation de construction (1) selon la revendication 1, comprenant en outre
une base de données (12) qui stocke les informations de construction, dans lequel dans le processus d'acquisition d'informations, les informations de construction sont acquises à partir de la base de données (12), et
dans le processus de génération d'informations de conception de réparation,
les informations de dommages sont générées sur la base d'une image bidimensionnelle de la construction incluse dans les informations de construction, les informations de construction étant acquises dans le processus d'acquisition d'informations, et
les informations de conception de réparation concernant une réparation des dommages dans la construction sont générées sur la base des informations de construction et des informations de dommages.

4. Appareil de support de réparation de construction (1) selon l'une quelconque des revendications 1 à 3, dans lequel
en réponse à l'acquisition d'une pluralité d'éléments d'informations de base de détermination incluant les informations de base de détermination, le processeur (10) est configuré pour calculer des éléments d'informations de degré de contribution qui indiquent respectivement des pourcentages de contribution de la pluralité d'éléments d'informations de base de détermination à la génération des informations de conception de réparation, et amener le dispositif d'affichage à afficher les éléments d'informations de degré de contribution correspondant respectivement à la pluralité d'éléments d'informations de base de détermination.

5. Appareil de support de réparation de construction (1) selon l'une quelconque des revendications 1 à 4, dans lequel
les informations de base de détermination incluent des informations de région concernant une région, sur la construction, à laquelle une attention doit être portée.

6. Appareil de support de réparation de construction (1) selon l'une quelconque des revendications 1 à 5, dans lequel
dans le processus de génération d'informations de conception de réparation, les informations de conception de réparation sont générées sur la base d'éléments d'informations de dommages à une pluralité d'instants temporels, et
les informations de base de détermination incluent un degré d'un changement dans le temps des éléments d'informations de dommages entre la pluralité d'instants temporels.

7. Appareil de support de réparation de construction (1) selon l'une quelconque des revendications 1 à 6, dans lequel
le processeur (10) est configuré pour effectuer un processus consistant à accepter la spécification des informations de conception de réparation par un utilisateur, et en réponse à l'acceptation de la spécification des informations de conception de réparation, amener le dispositif d'affichage à afficher les informations de base de détermination correspondant aux informations de conception de réparation, et/ou
le processeur (10) est configuré pour effectuer un processus consistant à accepter la spécification des informations de base de détermination par un utilisateur, et en réponse à l'acceptation de la spécification des informations de base de détermination, amener le dispositif d'affichage à afficher les informations de conception de réparation correspondant aux informations de base de détermination.

8. Appareil de support de réparation de construction (1) selon l'une quelconque des revendications 1 à 7, dans lequel
le processeur (10) inclut un premier modèle d'apprentissage configuré pour effectuer le processus de génération d'informations de conception de réparation, et
le premier modèle d'apprentissage fournit les informations de conception de réparation en réponse à une entrée des informations de construction ou à une entrée des informations de construction et des informations de dommages.

9. Appareil de support de réparation de construction (1) selon la revendication 8, dans lequel
dans le processus de génération de base de détermination effectué par le processeur (10), un processus de calcul pour un résultat de sortie du premier modèle d'apprentissage est retracé et les informations de base de détermination qui affectent le résultat de sortie sont extraites, et
par exemple,
dans le processus de génération de base de détermination effectué par le processeur (10), des informations visualisant une région du premier modèle d'apprentissage à laquelle une attention doit être portée sont générées en correspondance avec des informations entrées dans le premier modèle d'apprentissage, en tant qu'informations de base de détermination, et
de préférence,
dans le processus de génération de base de détermination effectué par le processeur (10), une carte thermique est générée en tant qu'informations visualisant une région à laquelle une attention, et
encore de préférence,
dans le processus de génération de base de détermination effectué par le processeur (10), la carte thermique est générée à l'aide de Grad-CAM, CAM ou Attention.

10. Appareil de support de réparation de construction (1) selon la revendication 2, dans lequel
le processeur (10) inclut un deuxième modèle d'apprentissage configuré pour effectuer le processus de génération d'informations de dommages, et
le deuxième modèle d'apprentissage fournit les informations de dommages concernant la construction en réponse à une entrée d'une image bidimensionnelle de la construction.

11. Procédé de support de réparation de construction pour un processeur pour effectuer une étape consistant à acquérir des informations de construction concernant une construction,
une étape consistant à générer des informations de conception de réparation concernant une réparation de dommages dans la construction sur la base des informations de construction et des informations de dommages concernant les dommages dans la construction,
une étape consistant à générer des informations qui contribuent à la génération des informations de conception de réparation, en tant qu'informations de base de détermination pour les informations de conception de réparation, et
une étape consistant à amener un dispositif d'affichage à afficher les informations de conception de réparation et les informations de base de détermination,
le procédé comprenant en outre :
acquérir des informations de position concernant les dommages dans la construction, et amener le dispositif d'affichage à afficher les informations de conception de réparation en association avec les informations de position, les informations de construction incluant des informations tridimensionnelles qui indiquent l'ensemble de la construction ;
amener le dispositif d'affichage à afficher la construction de manière tridimensionnelle sur la base des informations tridimensionnelles, et amener les informations de conception de réparation à être affichées à une position correspondante sur la construction affichée de manière tridimensionnelle, sur la base des informations de position concernant les dommages ;
effectuer un processus consistant à accepter la commutation entre l'affichage global et l'affichage local de la construction ;
en réponse à l'acceptation de la commutation de l'affichage global à l'affichage local et aux informations de position concernant les dommages, commuter l'affichage sur le dispositif d'affichage de l'affichage global de la construction sur la base des informations tridimensionnelles à l'affichage local qui inclut une image d'une position indiquée par les informations de position concernant les dommages, et amener le dispositif d'affichage à afficher les informations de base de détermination associées aux informations de position concernant les dommages ; et
en réponse à l'acceptation de la commutation de l'affichage local à l'affichage global, commuter l'affichage sur le dispositif d'affichage à l'affichage global, et amener le dispositif d'affichage à afficher les informations de conception de réparation en association avec les informations de position concernant les dommages.

12. Support d'enregistrement non transitoire lisible par ordinateur sur lequel est enregistré un programme pour amener un ordinateur à exécuter le procédé de support de réparation de construction selon la revendication 11.
